# EUROPÄISCHE PATENTSCHRIFT

(11) **EP 1 459 895 B1**
(45) Veröffentlichungstag und Bekanntmachung des Hinweises auf die Patenterteilung: **03.03.2010**
(21) Anmeldenummer: 04102929.9
(22) Anmeldetag: 16.09.1998
(51) Int. Cl.: B41F 33/14, G06F 3/033

(54) **Vorrichtung zum Einschalten einer Maschine**
Device for switching on a machine
Dispositif de mise en marche d'une machine

(30) Priorität: 21.10.1997 DE 19746323
(43) Veröffentlichungstag der Anmeldung: 22.09.2004
(62) Teilanmeldung aus: 98117535.9
(73) Patentinhaber: Heidelberger Druckmaschinen Aktiengesellschaft, 69115 Heidelberg (DE)
(72) Erfinder: Weil, Stefan, 68526, Ladenburg (DE)

(56) Entgegenhaltungen:
- EP-A- 0 284 007
- US-A- 4 639 881
- US-A- 5 526 422
- US-A- 5 627 567

## Beschreibung

Die Erfindung betrifft eine Vorrichtung zum Einschalten einer Maschine.

Maschinen mit Gefahrenpotential wie Druckmaschinen werden bisher zum Beispiel durch manuelle Betätigung eines elektromechanischen Tasters eingeschaltet. Ein solcher Taster verlangt eine bestimmte Mindest-Betätigungskraft und hat zweckmäßigerweise einen definierten Druckpunkt. Dadurch läßt sich ein unbeabsichtigtes Anfahren der Maschine zuverlässig verhindern, zumal wenn zusätzliche Sicherheitseinrichtungen wie akustische Anfahrwarnungen und Not-Aus-Taster vorgesehen sind. Aus EP 284 007 A ist eine Druckmaschinersteuervorrichtung bekannt, bei der berührungssensitive Teilflächen das Einschalten der Maschine übernehmen können. Ferner ist aus der EP 0 095 664 B2 eine Steuervorrichtung für eine Druckmaschine bekannt, bei der eine Befehlstaste zweimal gedrückt werden muß, damit der Befehl ausgeführt wird, um Fehlermöglichkeiten zu verringern.

Zur Vereinfachung der Bedienung wäre es wünschenswert, wenn das Einschalten der Maschine auch mit anderen Bedienelementen als elektromechanischen Schaltern oder Tastern erfolgen könnte. Solche Bedienelemente sind zum Beispiel berührungssensitive Bildschirme, sogenannte Touch-Screens, berührungssensitive Sensorfelder, sogenannte Touch-Pads, und Folientastaturen, wie sie bei Datenendgeräten, sogenannten Terminals, oder Personalcomputern verwendet werden. Ein Terminal oder Personalcomputer mit solchen Bedienelementen kann zwar zur Steuerung und/oder Überwachung vieler Funktionen einer Druckmaschine verwendet werden, gestattet aber aus Sicherheitsgründen bisher nicht das Anfahren der Druckmaschine, da die Bedienelemente leicht versehentlich auslösbar sind, beispielsweise durch versehentliches Berühren mit dem Finger oder durch Wischbewegungen, wie sie beim Reinigen eines Touch-Screens auftreten.

Der Erfindung liegt die Aufgabe zugrunde, berührungs- oder näherungssensitive Bedienelemente mit einem zuverlässigen Schutz vor Fehlauslösung zu versehen, um diese für Einschaltvorgänge bei Maschinen mit Gefahrenpotential verwenden zu können.

Die Vorrichtung gemäß der Erfindung, wie in Patentanspruch 1 angegeben, beruht auf dem Lösungsprinzip, sperrend wirkende Bereiche zu definieren, die von räumlicher Art sein können. Bei der Lösung mit sperrend wirkenden Teilflächen auf der Bedienfläche gibt es ein räumliches Raster, dem die Handhabung durch den Maschinenbediener entsprechen muß. Die Lösung verringert die Wahrscheinlichkeit für ungewollte Fehlauslösungen ganz erheblich.

In einer bevorzugten Ausführungsform sind der Sensor oder das Sensorfeld bzw. die Bedienfläche berührungssensitiv, wobei alternativ aber auch Näherungsschalter verwendet werden können, die bereits ansprechen, wenn sich ihnen ein Körperteil des Maschinenbedieners nähert. Die Erfindung eignet sich besonders für Touch-Screens und Touch-Pads als Bedienfläche, aber auch für Tastaturen, speziell Folientastaturen.

Mit der erfindungsgemäßen Vorrichtung ergibt sich eine hohe Sicherheit gegen Fehlauslösung, wenn die zweite Teilfläche oder die zweiten Teilflächen insgesamt eine wesentlich größere Fläche als die erste Teilfläche einnehmen bzw. wenn sie die zweite Teilfläche oder die zweiten Teilflächen in der Nähe der ersten Teilfläche angeordnet sind. In einer bevorzugten Ausführungsform für Touch-Screens oder Touch-Pads bildet die zweite Teilfläche eine zusammenhängende Fläche rings um die erste Teilfläche.

Die Erfindung ist nicht auf im wesentlichen ebene Bedienflächen wie Touch-Screens oder Touch-Pads beschränkt. Vielmehr bezieht sich der Ausdruck Bedienfläche auf jede Anordnung von Sensoren entlang einer Fläche, die im Raum gekrümmt oder winklig sein kann.

Die Erfindung ist besonders für Einschaltvorgänge bei Druckmaschinen, aber auch bei anderen Maschinen geeignet, beispielsweise Bindemaschinen, Schneidemaschinen und anderen Maschinen im Druckereiumfeld.

Weitere vorteilhafte Ausgestaltungen der Erfindung sind in den Unteransprüchen angegeben.

Ausführungsbeispiele der Erfindung sind in den Zeichnungen dargestellt und werden im folgenden näher beschrieben. Es zeigen:
- Fig. 1: eine Bedieneinheit in Form eines Personalcomputers oder Terminals mit TouchScreen, die mit einer Druckmaschinensteuerung verbunden ist,
- Fig. 2a; 2b: Ausführungsbeispiele für Bedienflächen mit sperrenden Teilflächen.

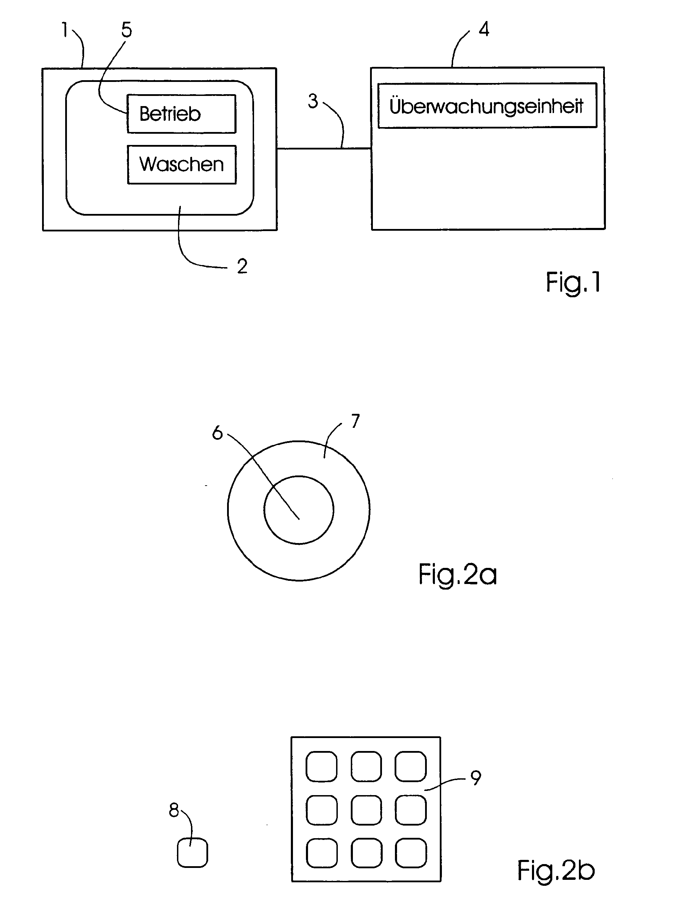

Die in Fig. 1 gezeigte Bedieneinheit 1 befindet sich am Leitstand einer Druckmaschine und umfaßt einen Personalcomputer oder ein Terminal mit einem Touch-Screen 2, der über eine elektrische oder optische Verbindung 3 (z.B. Kabel, HF-Leiter oder Lichtwellenleiter mit geeigneten Schnittstellen zur Datenübertragung) mit einer Druckmaschinensteuerung 4 verbunden ist. Während der Berührung eines Teilfeldes 5 mit der Aufschrift "Betrieb" auf dem Touch-Screen 2 durch den Maschinenbediener sendet die Bedieneinheit 1 ein Einschaltsignal an die Druckmaschinensteuerung 4, die eine Echtzeitsteuerung beliebiger Ausprägung sein kann. Auf dem Touch-Screen 2 können weitere Teilfelder vorgesehen sein, um weitere sicherheitsrelevante Vorgänge wie Waschen, Wendungsumstellung etc. auszulösen. Beispielsweise kann ein Teilfeld mit der Aufschrift "Waschen" vorgesehen sein, mit dem ein Waschbetrieb gestartet wird, wenn bestimmte Bedingungen erfüllt sind. Dies wird nachfolgend für das Beispiel der Inbetriebnahme der Druckmaschine beschrieben.

Eine Methode, das Einschalten einer Druckmaschine über einen Touch-Screen wie in Fig. 1 oder andere flächige Bedienelemente "Ein Fehler sicher" zu steuern, um ein unbeabsichtigtes Anfahren der Druckmaschine zu verhindern, ist in Fig. 2a gezeigt. Fig. 2a zeigt eine Ausschnittsansicht eines Touch-Screens, bei der eine Einschaltzone 6, die bei Berührung unmittelbar die Anfahrwarnung und den daran anschließenden Maschinenbetrieb auslöst, von einer ringförmigen Sperrzone 7 umgeben ist. Berühren der Sperrzone 7 sperrt für beispielsweise 10 Sekunden die Funktion der Einschaltzone 6.
Dadurch besteht nur eine sehr geringe Wahrscheinlichkeit für eine Fehlauslösung durch versehentliches Berühren oder beim Reinigen des Touch-Screens 2.

Das anhand von Fig. 2a erläuterte Prinzip kann auch auf andere Arten von Bedienflächen übertragen werden, die keine zusammenhängenden Flächen darstellen, sondern durch irgendeine Anordnung von diskreten Bedienelementen gebildet werden. Beispielsweise kann eine herkömmliche Tastatur wie eine Folientastatur oder eine Tastatur mit Druckpunkt-Tasten entsprechend eingerichtet werden. Fig. 2b zeigt einige Tasten einer solchen Tastatur, wobei eine einzige Taste 8 den Start der Druckmaschine auslöst und die Betätigung irgendeiner Taste aus einer Tastengruppe 9 die Funktion der Taste 8 für beispielsweise 20 Sekunden sperrt. Damit wird eine Fehlauslösung durch "Herumspielen" wesentlich unwahrscheinlicher. Anstelle nur einer Tastengruppe 9 wie in Fig. 2b können auch mehrere Tastengruppen, einige Tasten oder Tastengruppen rings um die Taste 8 herum oder sämtliche übrigen Tasten der Tastatur sperrend wirken. Ein weiteres Beispiel, auf welches das Prinzip von Fig. 2b anwendbar ist, ist eine Gruppe von verteilt angeordneten Näherungssensoren, von denen einer den Start auslöst und einige oder alle anderen sperrend wirken.

### Bezugszeichenliste

- 1: Bedieneinheit
- 2: Touch-Screen
- 3: Verbindung
- 4: Druckmaschinensteuerung
- 5: Teilfeld
- 6: Einschaltzone
- 7: Sperrzone
- 8: Taste
- 9: Tastengruppe

## Patentansprüche

1. Vorrichtung zum Einschalten einer Maschine, wobei die Vorrichtung
eine annäherungs- oder berührungssensitive Bedienfläche enthält, die eine erste Teilfläche (6; 8) aufweist, welche die Funktion eines Einschalters für die Maschine hat, **dadurch gekennzeichnet, dass** die Vorrichtung wenigstens eine zweite Teilfläche (7; 9) aufweist, welche in Reaktion auf eine Annäherung oder Berührung die Funktion der ersten Teilfläche eine vorbestimmte Zeit lang sperrt, wobei die zweite Teilfläche (7, 9) oder die zweiten Teilflächen rings um die erste Teilfläche (6; 8) herum angeordnet sind.

2. Vorrichtung nach Anspruch 1,
**dadurch gekennzeichnet,**
**dass** die zweite Teilfläche (7; 9) oder die zweiten Teilflächen insgesamt eine wesentlich größere Fläche als die erste Teilfläche (6; 8) einnehmen.

3. Vorrichtung nach Anspruch 1 oder 2,
**dadurch gekennzeichnet,**
**dass** die zweite Teilfläche (7; 9) oder die zweiten Teilflächen in der Nähe der ersten Teilfläche (6; 8) angeordnet sind.

4. Vorrichtung nach Anspruch 3,
**dadurch gekennzeichnet,**
**dass** eine zweite Teilfläche (7) vorgesehen ist, welche eine zusammenhängende Fläche rings um die erste Teilfläche (6) bildet.

5. Vorrichtung nach einem der Ansprüche 1 bis 4,
**dadurch gekennzeichnet,**
**dass** die Bedienfläche im Wesentlichen eben ist.

6. Vorrichtung nach Anspruch 5,
**dadurch gekennzeichnet,**
**dass** die Bedienfläche ein berührungssensitiver Bildschirm ist, der Teilbilder anzeigt, welche die ersten und zweiten Teilflächen bilden.

7. Vorrichtung nach Anspruch 6,
**dadurch gekennzeichnet,**
**dass** die Bedienfläche ein berührungssensitives Sensorfeld ist.

8. Vorrichtung nach Anspruch 6,
**dadurch gekennzeichnet,**
**dass** die Bedienfläche eine Tastatur ist, mit einer Taste (8), welche die erste Teilfläche bildet, und mit mehreren weiteren Tasten (9), welche die zweite Teilfläche oder die zweiten Teilfläche bilden.

9. Vorrichtung nach einem der Ansprüche 1 bis 8,
**dadurch gekennzeichnet,**
**dass** die vorbestimmte Zeit, während der die Funktion der ersten Teilfläche in Reaktion auf eine Annäherung oder Berührung der zweiten Teilfläche gesperrt ist, ungefähr 5 bis 30 Sekunden beträgt.

10. Vorrichtung nach einem der Ansprüche 1 bis 10,
**dadurch gekennzeichnet,**
**dass** die Maschine eine Druckmaschine ist.

## Claims

1. A device for switching on a machine, wherein the device has an operating area which is sensitive to movement or touch, comprising a first partial area (6; 8), which has the function of an on switch for the machine, **characterized in that** said device has at least one second partial area (7; 9), which disables the functioning of said first partial area for a specified period of time in reaction to movement or touch, wherein said second partial area (7; 9) or said second partial areas are arranged around said first partial area (6; 8).

2. The device according to claim 1, **characterized in that** said second partial area (7; 9) or said second partial areas have a significantly larger total area than said first partial area (6; 8).

3. The device according to claim 1 or 2, **characterized in that** said second partial area (7; 9) or said second partial areas are arranged in the vicinity of said first partial area (6; 8).

4. The device according to claim 3, **characterized in that** provision is made for a second partial area (7) which forms a continuous area around said first partial area (6).

5. The device according to any one of the claims 1 to 4, **characterized in that** said operating area is substantially even.

6. The device according to claim 5, **characterized in that** said operating area is a touch-sensitive screen displaying partial images forming said first and second partial areas.

7. The device according to claim 6, **characterized in that** said operating area is a touch-sensitive sensor field.

8. The device according to claim 6, **characterized in that** said operating area is a keypad with one key (8) forming said first partial area, and with several additional keys (9) forming said second partial area or said second partial areas.

9. The device according to any one of the claims 1 to 8, **characterized in that** the specified time period during which the function of said first partial area is disabled as a result of approaching or touching said second partial area is approximately 5 to 30 seconds.

10. The device according to any one of claims 1 to 10, **characterized in that** the machine is a printing press.

## Revendications

1. Dispositif pour la mise en route d'une machine, le dispositif comportant une surface de commande réactive au toucher ou à l'approche qui présente une première surface partielle (6; 8) qui a la fonction d'un interrupteur pour la machine, **caractérisé en ce que** le dispositif présente au moins une seconde surface partielle (7; 9) qui bloque pendant un temps déterminé la fonction de la première surface partielle en réaction à une approche ou un toucher, la seconde surface partielle (7, 9) ou les secondes surfaces partielles étant disposées tout autour de la première surface partielle (6; 8).

2. Dispositif selon la revendication 1, **caractérisé en ce que** la seconde surface partielle (7; 9) ou les secondes surfaces partielles prennent dans l'ensemble une surface plus importante que la première surface partielle (6; 8).

3. Dispositif selon la revendication 1 ou 2, **caractérisé en ce que** la seconde surface partielle (7; 9) ou les secondes surfaces partielles sont disposées à proximité de la première surface partielle (6; 8).

4. Dispositif selon la revendication 3, **caractérisé en ce qu'**il est prévu une seconde surface partielle (7) qui forme une surface concordante tout autour de la première surface partielle (6).

5. Dispositif selon l'une des revendications 1 à 4, **caractérisé en ce que** la surface de commande est sensiblement plane.

6. Dispositif selon la revendication 5, **caractérisé en ce que** la surface de commande est un écran tactile qui affiche des images partielles formant les premières et secondes surfaces partielles.

7. Dispositif selon la revendication 6, **caractérisé en ce que** la surface de commande est un champ de capteur tactile.

8. Dispositif selon la revendication 6, **caractérisé en ce que** la surface de commande est un clavier avec une touche (8) qui forme la première surface partielle et avec plusieurs touches (9) qui forment la seconde surface partielle ou les secondes surfaces partielles

9. Dispositif selon l'une des revendications 1 à 8, **caractérisé en ce que** le temps prédéterminé pendant lequel la fonction de la première surface partielle est bloquée en réaction à une approche ou un toucher de la seconde surface partielle est d'environ 5 à 30 secondes.

10. Dispositif selon l'une des revendications 1 à 10, **caractérisé en ce que** la machine est une machine d'impression.
